# EUROPÄISCHE PATENTANMELDUNG

(11) **EP 0 716 563 A2**
(43) Veröffentlichungstag der Anmeldung: **12.06.1996**
(21) Anmeldenummer: 95118994.3
(22) Anmeldetag: 01.12.1995
(51) Int. Cl.: H05K 3/32

(54) **Verfahren zur Kontaktierung des Anschlussdrahtes eines elektrischen Bauelementes und nach diesem Verfahren hergestellte Anordnung**

(30) Priorität: 05.12.1994 DE 4443201
(71) Anmelder: SIEMENS AKTIENGESELLSCHAFT, D-80333 München (DE)
(72) Erfinder: Kern, Josef, D-13629 Berlin (DE)

(57) **Zusammenfassung**

Zur Kontaktierung von Anschlußdrähten (4, 5) eines Bauelementes (3) in Löchern (6) einer Blech-Platine (1) wird der Lochrand durch ringförmige Einkerbungen (7) nach innen verformt, so daß jeweils eine Quetschverbindung (8) mit dem Anschlußdraht (4, 5) entsteht. Dadurch wird eine form- und kraftschlüssige Verbindung ohne die Anwendung von Löt- und Flußmitteln erreicht.

## Beschreibung

Die Erfindung betrifft ein Verfahren zur Kontaktierung des Anschlußdrahtes eines elektrischen Bauelementes auf einer Blech-Platine, wobei der Anschlußdraht durch ein Loch der Platine gesteckt und darin fixiert wird. Außerdem betrifft die Erfindung eine nach diesem Verfahren hergestellte Anordnung.

In elektrischen Baugruppen zum Schalten höherer Ströme ist es häufig erforderlich, Bauelemente, wie Widerstände und Dioden, mit Stromführungsschienen aus Kupfer oder einer Kupferlegierung zu verbinden. Dies ist besonders der Fall in der Automobiltechnik, wo in Relais oder in mit Relais bestückten Modulen und Baugruppen solche zusätzlichen Bauelemente kontaktiert werden müssen. Da wegen der hohen Ströme herkömmliche Leiterplatten nicht eingesetzt werden können, dienen als Stromführungsschienen Blechplatinen bzw. Stanzgitter aus entsprechend dickem Material, die beispielsweise zum Teil mit Kunststoff umspritzt sind. Bisher wurden solche zusätzlichen Bauelemente durch Handlötung an weniger zugänglichen Stellen oder durch automatische Weichlötung an ebenen Platinen mit den relativ dicken Stromführungsschienen verbunden. Üblich ist auch eine Widerstandsschweißung, wobei in diesem Fall jedoch die dicken Platinen zunächst mit einer erhabenen Schweißwarze versehen sein müssen, damit die dünnen Anschlußdrähte aufgeschweißt werden können. Die bei der Lötung erforderlichen Flußmittel und die bei einer Schweißung zwangsläufig auftretenden Materialspritzer ergeben jedoch eine unerwünschte Verunreinigung, die besonders für die in der Baugruppe befindlichen Schaltkontakte schädlich sind und zu Störungen führen können.

Ziel der vorliegenden Erfindung ist es, ein Verfahren zur form- und kraftschlüssigen Verbindung zwischen Anschlußdrähten eines Bauelementes und einer Stromführungs-Platine anzugeben, bei dem die Platine, abgesehen von einer Lochung, keiner besondere Vorbehandlung zur Formgebung bedarf und bei dem auch keine zusätzlichen Verbindungsstoffe, wie Lötmittel und dergleichen, erforderlich sind.

Erfindungsgemäß wird dieses Ziel bei einem Verfahren der eingangs genannten Art dadurch erreicht, daß mindestens auf einer Seite der Platine mindestens ein Segment des Lochrandes durch einen Kerbstempel zu dem Anschlußdraht hin verformt wird und den Anschlußdraht unter Deformation seines Querschnitts einklemmt.

Bei dem erfindungsgemäßen Verfahren wird also die Platine im Bereich neben dem Kontaktloch bzw. rund um das Kontaktloch eingekerbt und zu dem Loch bzw. zu dem Anschlußdraht hin verformt, wobei dieser eingequetscht und damit form- und kraftschlüssig fixiert wird. Diese Verformung erfolgt aus der ebenen Platine heraus, so daß eine Vorbehandlung, wie das Aufbiegen einer Lasche oder eines Schweißbuckels, nicht erforderlich ist. Dabei kann diese Art der Verbindung sowohl an einem Stanz- oder Biegeteil innerhalb eines Relais als auch an einer Leiterplatte in Form eines umspritzten Stanzgitters oder in einer entsprechenden Relais-Box angewendet werden.

Vorzugsweise läßt man bei der Kontaktierung zwei Kerbstempel koaxial gegeneinander wirken, so daß die Lochränder auf beiden Seiten der Platine verformt werden. Vorzugsweise sind die den Anschlußdraht bzw. das Kontaktloch ringförmig umgebenden Kerbstempel geschlitzt, so daß jeweils zwei halbrundförmige Schneiden gegeneinander wirken. Auf diese Weise wird ein Materialfluß in der Platine erzeugt, der den Anschlußdraht zu einem ovalen Querschnitt verformt. Ein solcher ovaler Querschnitt erhöht die Verdrehsicherheit und den Formschluß der Quetschverbindung. Natürlich sind aber auch andere, nicht runde Querschnittsformen denkbar und möglich.

Die Erfindung wird nachfolgend an einem Ausführungsbeispiel anhand der Zeichnung näher erläutert. Es zeigen
Figuren 1 und 2 eine umspritzte Platine mit einem erfindungsgemäß befestigten Bauelement in einer Schnittansicht und in Draufsicht,
Figur 3, 4 und 5 eine Werkzeuganordnung zur Herstellung einer Verbindung gemäß Figur 1 in zwei Arbeitsphasen und
Figur 6 eine Schnittansicht VI-VI aus Figur 5.

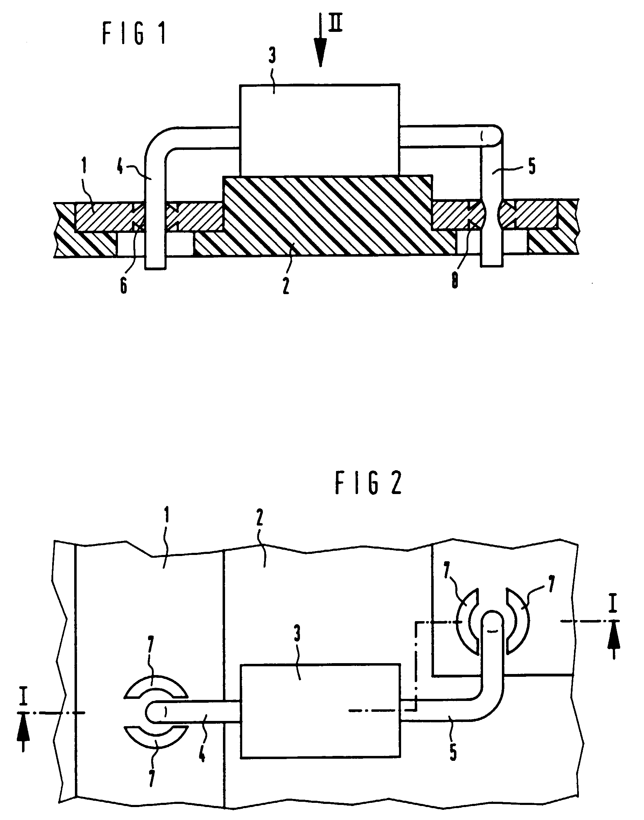

Die in den Figuren 1 und 2 gezeigte Anordnung zeigt ausschnittsweise eine Blech-Platine 1, vorzugsweise Teil eines Stanzgitters aus Kupfer oder einer Kupferlegierung, die teilweise in einen Isolierstoffträger 2 eingebettet ist. Auf der Platine 1 ist ein Bauelement 3, beispielsweise ein Widerstand oder eine Diode, mit zwei Anschlußdrähten 4 und 5 befestigt und kontaktiert, wobei die Anschlußdrähte abgewinkelt und in Bohrungen 6 der Platine eingesteckt sind. Durch halbringförmige Einkerbungen 7 ist der Rand der Bohrung 6 jeweils an zwei gegenüberliegenden Seiten nach innen zu den Anschlußdrähten 4 bzw. 5 hin deformiert, wodurch sich jeweils eine Quetschverbindung 8 zwischen dem jeweiligen Anschlußdraht und der Platine ergibt.

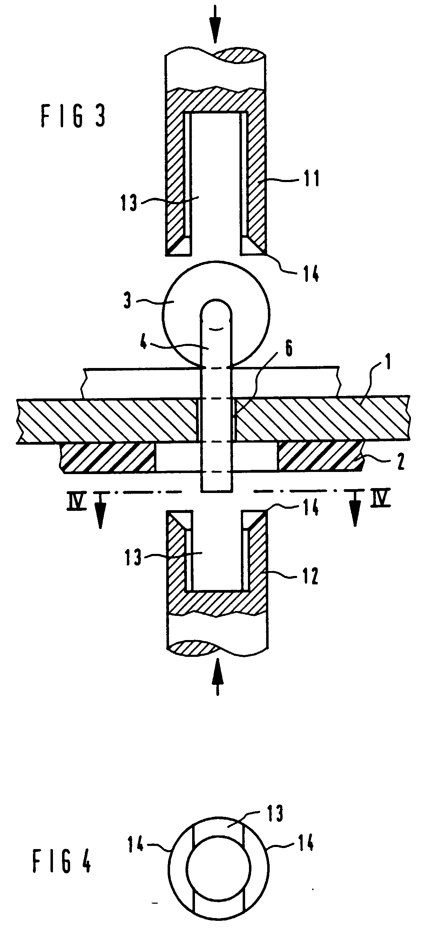

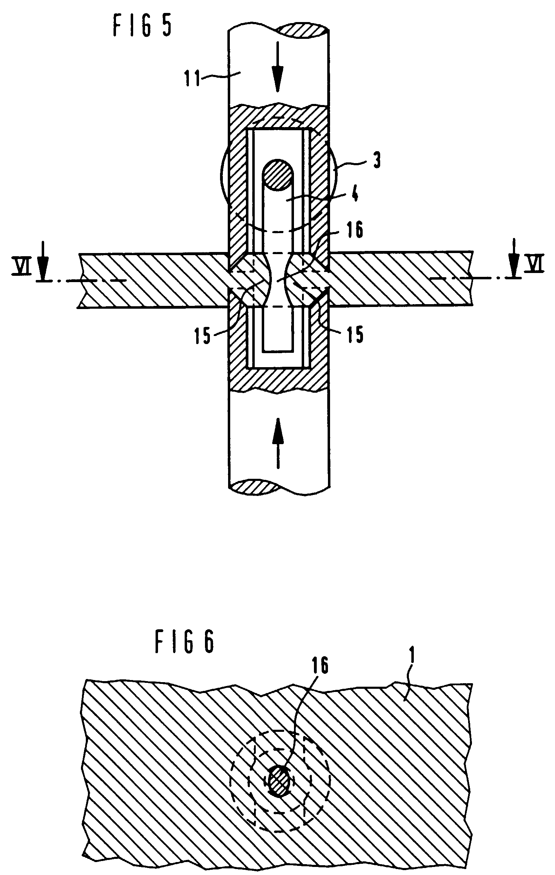

In Figur 3 ist eine Werkzeuganordnung zur Herstellung der Quetschverbindung von Figur 1 gezeigt. Nachdem das Bauteil 3 mit seinem Anschlußdraht 4 in die Bohrung 6 der Platine 1 eingesteckt ist, wird mit einem Kerb-Oberstempel 11 von der Oberseite und mit einem Kerb-Unterstempel 12 gleichzeitig von der Unterseite auf die Platine 1 so gedrückt, daß der Rand des Loches 6 nach innen deformiert wird. Die beiden Kerbstempel 11 und 12 besitzen jeweils einen Schlitz 13, wodurch zwei kreissegmentförmige Schneiden 14 gebildet werden. Figur 4 zeigt die Schneide 14 des Unter-Kerbstempels 12 in einer Draufsicht IV-IV aus Figur 3. Der Schlitz 13 schafft einerseits Platz für die Durchführung des abgewinkelten Anschlußdrahtes 4 vom Bauteil 3 her, andererseits wird auf diese Weise ein Materialfluß in der Platine erzeugt, der den Anschlußdraht zu einem ovalen Querschnitt verformt. Dieser ovale Querschnitt erhöht die Verdrehsicherheit und den Formschluß der Quetschverbindung.

Den Zustand nach dem Schließen der Kerbstempel zeigt Figur 5. Der durch die Kerbstempel 11 und 12 nach innen verformte Quetschrand 15 der Platine 1 deformiert den Quetschbereich 16 des Anschlußdrahtes 4 zu einem ovalen Querschnitt, wie er in der Schnittansicht von Figur 6 zu sehen ist.

Für den oben erwähnten Durchtritt des abgewinkelten Anschlußdrahtes 4 durch den Stempel würde grundsätzlich auch bereits ein einseitiger Schlitz im Oberstempel 11 ausreichen. Der Unterstempel 12 könnte, da bei ihm kein Draht durchgeführt werden muß, auch als geschlossener kreisförmiger Ringstempel ausgebildet sein. Im übrigen könnten die Kerbstempel natürlich anstelle der Kreisringform auch beliebige andere Formen annehmen, soweit diese wirtschaftlich herstellbar und handhabbar sind.

## Patentansprüche

1. Verfahren zur Kontaktierung des Anschlußdrahtes eines elektrischen Bauelementes auf einer Blech-Platine (1), wobei der Anschlußdraht (4, 5) durch ein Loch (6) der Platine (1) gesteckt und darin fixiert wird, **dadurch gekennzeichnet**, daß mindestens auf einer Seite der Platine (1) mindestens ein Segment des Lochrandes durch einen Kerbstempel (11, 12) zu dem Anschlußdraht (4) hin verformt wird und den Anschlußdraht (4) unter Deformation seines Querschnittes einklemmt.

2. Verfahren nach Anspruch 1, **dadurch gekennzeichnet**, daß mittels zweier gegeneinander wirkender Kerbstempel (11, 12) der Lochrand (15) durch Einkerbungen auf beiden Seiten der Platine (1) verformt wird.

3. Verfahren nach Anspruch 1 oder 2, **dadurch gekennzeichnet**, daß der Lochrand (15) jeweils durch ringförmig den Anschlußdraht (4) umschließende Einkerbungen (7) verformt wird.

4. Verfahren nach Anspruch 3, **dadurch gekennzeichnet**, daß durch Einkerbungen (7) in Form zweier einander gegenüberstehender Ringsegmente der Anschlußdraht (4) zu einem ovalen Querschnitt (16) deformiert wird.

5. Nach dem Verfahren gemäß einem der Ansprüche 1 bis 4 hergestellte Anordnung eines elektrischen Bauelementes (3) auf einer Blech-Platine (1), wobei jeweils ein Anschlußdraht (4, 5) des Bauelementes in einem Loch (6) der Platine (1) befestigt ist, **dadurch gekennzeichnet**, daß der Anschlußdraht (4, 5) senkrecht zur Platinenebene in dem Loch (6) stehend durch eine Quetschverbindung (8) befestigt ist.

6. Anordnung nach Anspruch 5, **dadurch gekennzeichnet**, daß die Platine (1) teilweise in Isolierstoff (2) eingebettet ist, wobei der jeweilige Lochrand für den Angriff eines Kerbstempels freigespart ist.
